Europäisches Patentamt

European Patent Office

Office européen des brevets

(11) Publication number: **0 173 764**
**B1**

# EUROPEAN PATENT SPECIFICATION

(45) Date of publication of patent specification: **13.12.89**

(51) Int. Cl.4: **C 30 B 15/30**

(21) Application number: **84111305.3**

(22) Date of filing: **21.09.84**

(54) **Single crystal growing method and apparatus.**

(30) Priority: **31.08.84 JP 182435/84**
**31.08.84 JP 182436/84**
**31.08.84 JP 182437/84**

(43) Date of publication of application:
**12.03.86 Bulletin 86/11**

(45) Publication of the grant of the patent:
**13.12.89 Bulletin 89/50**

(84) Designated Contracting States:
**DE FR GB IT**

(73) Proprietor: **GAKEI ELECTRIC WORKS CO., LTD.**
**18-9, Senjyu-sakuragi 2-chome Adachi-ku**
**Tokyo (JP)**

(72) Inventor: **Nishizawa, Minoru**
**33-3, Senjyu-motomachi Adachi-ku**
**Tokyo (JP)**

(74) Representative: **Patentanwälte Viering &**
**Jentschura**
**Steinsdorfstrasse 6**
**D-8000 München 22 (DE)**

(56) References cited:
EP-A-0 174 391
FR-A-2 099 638
GB-A-2 084 046

PATENTS ABSTRACTS OF JAPAN, vol. 8, no. 19
(C-207) 1456r, January 26, 1984; & JP - A - 58 185
493 (HITACHI SEISAKUSHO K.K.) 29-10-1983

IBM TECHNICAL DISCLOSURE BULLETIN, vol.
10, no. 7, December 1967, pages 1076-1077, New
York, US; L.H. BLAKE et al.: "Heat shield to
reduce stress during crystal growth"

(56) References cited:
PATENTS ABSTRACTS OF JAPAN, vol. 8, no. 30,
(C-209) 1467r, February 8, 1984; & JP - A - 58 194
793 (NIPPON DENKI K.K.) 12-11-1983

PATENTS ABSTRACTS OF JAPAN, vol. 8, no. 62
(C-215) 1499r, March 23, 1984; & JP - A - 58 217
494 (NIPPON DENSHIN DENWA KOSHA) 17-12-
1983

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

Background of the invention
1. Field of the invention

The present invention relates to a single crystal growing method and apparatus suitable for use in pulling up a compound semiconductor of elements of Groups III—V, especially gallium arsenide (GaAs), according to the Czochralski method.

2. Description of the prior art

In order for compound semiconductors of this sort to fully exhibit their intrinsic optical and electrical characteristics, it is necessary that the single crystals as their materials have a high purity and a high perfectness of crystal.

Compound semiconductors of elements of Groups III—V such as GaAs, gallium phosphide (GaP) and indium phosphide (InP) melt as high as 1238°C, 1470°C and 1050°C and exhibit high dissociation pressures (0.9, 30 and 15.5 bar respectively) at such melting points. It is extremely difficult to grow these compound semiconductors according to the pulling-up method.

Especially, as to a single crystal of GaAs, there is an increasing demand for it as an electronic material because of a larger electron transfer degree than silicon (Si) when compared in about the same dimensional accuracy.

As the method of obtaining such GaAs single crystal, the horizontal Bridgman method is well known, but this method involves the problem of contamination caused by impurities from a quartz board or a quartz sealed tube, or the problem that the sectional shape of a grown crystal does not become circular. Recently, because of these problems, it has very often been tried to grow such single crystal according to the Czochralski method.

According to the Czochralski method, there can be obtained a single crystal of a higher purity than that obtained according to the horizontal Bridgman method, but there is a problem in point of perfectness of crystal, and so various researches are being made incessantly in order to obtain a crystal of a smaller dislocation density.

It is well known that the presence of dislocation would cause electrical and optical characteristics of a semiconductor device using this material to be deteriorated or show abnormality.

Such dislocation is sometimes created during the device manufacturing process, but in most cases it is present from the beginning in GaAs single crystal as a substrate. The dislocation present in the substrate is caused mainly by a heat distortion in the production of a single crystal, and this heat distortion is sometimes caused by an abrupt temperature gradient in the interior of the crystal induced by convection of an inert gas which occurs in an inert gas atmosphere of a high pressure in a furnace, but one major cause has been considered to be a non-uniform temperature distribution at the solid-melt interface caused by a heat convection which occurs in a feed melt.

To prevent such heat convection, there has been developed a technique of floating a heat convection preventing plate in a position below the surface of a feed melt in pulling up a single crystal, the heat convection preventing plate having a diameter somewhat larger than that of the single crystal and fairly smaller than that of a crucible. This technique is effective against a heat convection from the center toward the outside occurring in the feed melt, but is not always fully effective against a heat convection from the outside toward the center.

There has also been developed a technique of floating a convection preventing plate in a position below the surface of a feed melt by virtue of its buoyancy, the convection preventing plate having a diameter larger than that of a single crystal being pulled up and somewhat smaller than the inside diameter of a crucible, and conducting the feed melt upward beyond the convection preventing plate through fine holes formed in the same plate or through a gap formed between the outer periphery of the convection preventing plate and the inner periphery of the crucible. But, where the feed melt is viscous, it does not pass smoothly through the fine holes and the gap, thus taking much time for the pulling-up operation, and carelessness would cause deficiency of the feed melt in the single crystal pulling-up portion.

As a further cause of dislocation, due to a heat radiation from a liquid sealing agent such as $B_2O_3$ which covers the upper surface of a feed melt, and lowering of the feed melt level in a crucible at the end of the single crystal pulling-up operation as compared with that at the beginning of the same operation, the crucible per se plays the role of a heat retaining cylinder as the single crystal pulling-up operation advances, thus making it extremely difficult to effect temperature control (control of a constant temperature gradient).

Objects and summary of the invention

It is a primary object of the present invention to provide a single crystal growing method and apparatus capable of obtaining a crystal of a high purity and a small dislocation density in producing according to the Czochralski method a single crystal having a high melting point and exhibiting a high dissociation pressure at the said melting point such as a compound semiconductor of elements of Groups III—V.

It is a secondary object of the present invention to provide a single crystal growing method and apparatus in which a heat convection of a feed melt can be completely prevented from affecting the single crystal pulling-up portion or the solid-melt interface, and the feed melt can be fed smoothly onto the solid-melt interface without excess or deficiency through a gap formed between the outer periphery of a baffle plate and the inner wall of a crucible.

It is a further object of the present invention to provide an apparatus capable of measuring and controlling the temperature of a desired region in the crucible.

The present invention is defined in independent claims 1 and 10.

According to the present invention, in order to achieve the abovementioned technical subjects in pulling up a single crystal from a feed melt, a baffle plate having an outside diameter somewhat smaller than the inside diameter of a crucible and also having a feed melt guiding portion where at least its outer periphery is floated vertically movably in a predetermined position below the surface of the feed melt, maintains a predetermined spacing from the surface of the feed melt under rotation of the crucible and/or the baffle plate during the single crystal pulling-up operation.

Moreover, in order to prevent impurity contamination, the baffle plate is formed of alumina ($Al_2O_3$), silicon nitride ($Si_3N_4$), BN (boron nitride) or PBN (pyrolytic boron nitride), and a molybdenum heater is used.

Further, the baffle plate is held down from above by or fixed to a plurality of moving rods which are suspended vertically movably, in order to maintain its predetermined position, while the crucible is moved up and down.

According to the present invention, moreover, in pulling up a single crystal by the liquid encapsulated method, the interior of a furnace is held in a high pressure gas atmosphere; a baffle plate is floated in a predetermined position below the surface of a feed melt; a control is made to maintain the spacing between the baffle plate and the feed melt surface at a predetermined spacing during the single crystal pulling-up operation; and a plurality of heating means are coaxially provided around a crucible and the heating of the crucible by these heating means is controlled independently.

According to the present invention, moreover, in pulling up a single crystal from a feed melt, there are provided a plurality of heating means and a temperature measuring means movable axially into a crucible which contains a feed melt, and the heating means are controlled each independently in accordance with a detected signal provided from the temperature measuring means while measuring the temperature of a desired region in the crucible by the temperature measuring means.

Further, according to the present invention, in the case of floating a baffle plate in a feed melt contained in a crucible, a temperature measuring means is enclosed in a single or plural moving rods which support or hold the baffle plate.

Moreover, the single crystal pulling-up apparatus of the present invention comprises a pressure- and heat-resistant electric furnace, a single crystal pulling-up shaft which is driven within the electric furnace by a magnetic mechanism, a feed melt holding crucible placed and fixed on the upper portion of a crucible supporting rod which is also driven within the electric furnace by a magnetic mechanism, a liquid sealing agent floated on the surface of the feed melt in the crucible, a baffle plate held in a predetermined position below the feed melt surface, means for maintaining the spacing between the baffle plate and the feed melt surface at a predetermined spacing with pulling up of a single crystal, a plurality of heating means mounted in an axially vertically arranged fashion around the outside of the crucible, and means for controlling the heating means each independently.

Under the construction described above of the invention, a heat convection created in the feed melt does not affect the solid-melt interface, and the temperature variation and temperature distribution at this area can be rendered flat and uniform, and it is possible to prevent heat radiation through the liquid sealing agent; further, the temperature of the feed melt, the solid-melt interface or the liquid sealing agent can be measured directly and accurately during the single crystal pulling-up operation, and by controlling the plural heating means in accordance with detected signals, it is made possible to make an accurate temperature control with little temperature variation and thereby minimize the occurrence of a heat distortion, so that the dislocation caused by such heat distortion is prevented and a single crystal of an extremely small dislocation density can be obtained, besides, the impurity contamination can be minimized.

In the present invention, moreover, by holding the furnace interior in a high pressure gas atmosphere, it is possible to prevent the dissipation of a volatile component, and even in such high pressure gas atmosphere the gas-tightness can be ensured completely, under which condition a smooth movement of the drive system is ensured; further, the baffle plate can be held in a predetermined position in the crucible in an extremely stable during the single crystal pulling-up operation.

The above and other objects, features and advantages of the invention will become clear from the following description of the preferred embodiment taken in conjunction with the accompanying drawings.

Brief description of the drawings

Fig. 1 is a schematic view illustrative of the present invention;

Fig. 2 is a perspective view of a baffle plate;

Fig. 3 is a view illustrative of temperature gradient and temperature variation;

Fig. 4 is a schematic view illustrating a further embodiment of the invention.

Description of the preferred embodiments

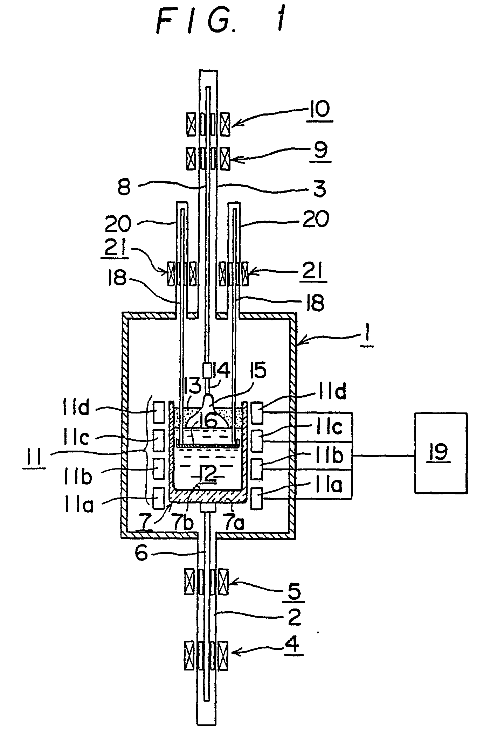

Referring first to Figs. 1 to 3, the reference numeral 1 denotes a pressure- and heat-resistant electric furnace of a completely closed structure with thin-walled cylinders 2 and 3 centrally projecting axially vertically therefrom. The electric furnace 1 is made of stainless steel, for example. In the lower cylinder 2 is enclosed gas-tightly a crucible supporting rod 6, with a vertical movement drive mechanism 4 and a rotation drive mechanism 5 being disposed therearound, both drive mechanisms 4 and 5 utilizing a magnetic force. On the upper end portion of the crucible supporting rod 6 is fixed a crucible 7 comprising an outer crucible 7a formed of, for example, graphite and an inner crucible 7b formed of, for example, quartz. In the upper cylinder 3 is enclosed gas-tightly a single crystal pulling-up rod 8 with a vertical movement drive mechanism 10 and a rotation drive mechanism 9 being disposed therearound, both drive mechanisms 10 and 9 utilizing a magnetic force. Outside the crucible 7 are coaxially disposed a heating means 11 comprising heaters 11a, 11b, 11c and 11d which are independent of one another and which are formed of molybdenum, for example. The heaters 11a, 11b, 11c and 11d are controlled independently in accordance with a signal provided from a thermocouple (not shown) by means of a temperature control box 19 so that a predetermined temperature gradient is created in which the higher the position in the crucible, the lower the temperature. In the crucible 7 is contained a feed melt 12, e.g. GaAs, the upper surface of which is covered with a liquid sealing agent 13, e.g. $B_2O_3$. In the illustrated embodiment, a GaAs single crystal 15 is being pulled up through a seed crystal 14 attached to the fore end of the single crystal pulling-up rod 8 and through the liquid sealing agent 13.

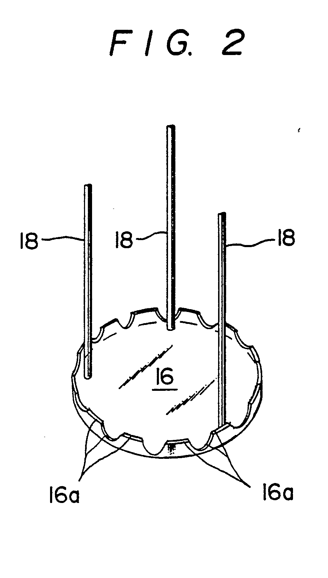

In a predetermined position below the surface of the feed melt 12 is floated a baffle plate 16 by being held down at its upper surface by moving rods 18 which are suspended from above the crucible 7, the baffle plate 16 having an outside diameter somewhat smaller than the inside diameter of the crucible 7. The baffle plate 16, as shown in Fig. 2, has a feed melt guiding portion 16a such as a wavy unevenness on the upper surface of its outer periphery and it is formed of $Al_2O_3$, $Si_3N_4$, BN, or PBN. The moving rods are formed of BN, for example and are provided three. These three moving rods are suspended from cylinders 20 which are radially erected on the electric furnace 1 so as to constitute a regular triangle with the upper cylinder as the center and which have each a closed upper end. The thus-suspended moving rods 18 are adapted to be vertically moved simultaneously by means of drive mechanisms 21 which utilize a magnetic force.

Thus, the moving shafts such as the crucible moving rod 6, single crystal pulling-up rod 8 and moving rods 18 are driven by the drive mechanisms utilizing a magnetic force, so even when the interior of the electric furnace 1 is filled with an inert gas of a high pressure, the gas-tightness of the furnace is fully maintained and the moving shafts can be moved smoothly in the high pressure atmosphere.

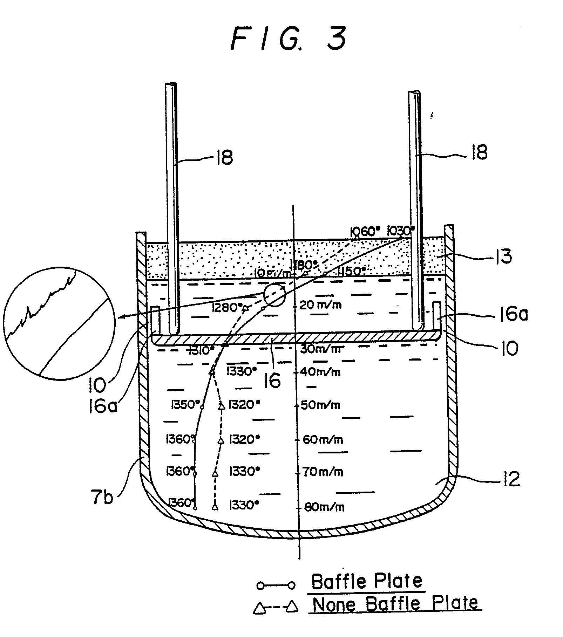

Further, since the outside diameter of the baffle plate 16 is a little smaller than the inside diameter of the crucible 7, not only a heat convection of the feed melt 12 occurring below the baffle plate 16 and advancing from the center toward the outside, but also such heat convection advancing from the outside toward the center, are obstructed by the baffle plate 16 and have no influence upon the upper surface of the baffle plate 16. Consequently, as shown in Fig. 3, the temperature of the solid-melt interface region on the upper surface of the baffle plate 16 is extremely stable in comparison with the case where the baffle plate is not used.

Further, in the case of holding the heaters 11a, 11b and 11c at 1400°C and the heater 11d at 1200°C, as shown also in Fig. 3, the temperature is higher by 30°C in a lower position of the crucible and lower by 30°C on the upper surface of $B_2O_3$ than in the absence of the baffle plate 16. Thus, the single crystal being pulled up could be prevented from thermally distorted by the radiation heat from $B_2O_3$.

Further, in the case where the feed melt guiding portion 16a is formed on the upper surface of the outer periphery of the baffle plate 16, the guiding portion 16a functions to roll in and suck up the feed melt 12 from the lower surface to the upper surface of the baffle plate 16 through a gap (a) with rotation of the baffle plate 16 or the crucible 7, whereby the feed melt 12 can be fed always smoothly to the solid-melt interface region above the baffle plate 16 without excess or deficiency. In this respect, a superior effect could be exhibited as compared with the construction in which the feed melt is passed through fine holes formed in the baffle plate 16 itself or through a gap formed between the outer periphery of a flat baffle plate and the inner wall of the crucible.

Further, since the guiding portion 16a functions to guide the feed melt from the outer periphery of the baffle plate 16 to the sold-melt interface region on the upper central portion of the crucible 7, the temperature of the guided feed melt falls a little in the meantime so that the temperature distribution of the solid-melt interface region can be prevented from being disordered.

Further, since the guiding portion 16a functions to stir the feed melt on the baffle plate 16, the growth of the single crystal is sped up.

The guiding portion 16a may be constituted by plural openings which are formed in a periphery wall of the baffle plate 16. The guiding portion 16a also may be constituted by plural openings or the wavy unevenness which are formed in a radius direction of the baffle plate 16. The plural openings and the wavy unevenness may be shaped edges for cutting the feed melt.

It has further been found out that in the case of using molybdenum wires as the heaters 11a, 11b, 11c and 11d, the impurity contamination from those molybdenum wire heaters is minimized. The baffle plate 16 may be fixed to the fore ends of the moving rods 18, and in this case only a single moving rod may be used. In the case of fixing the baffle plate 16 to the moving rods 18, there is the advantage that the baffle plate 16 can be used repeatedly. But, in some particularly positions of a peep glass, the baffle plate may obstruct the view of the peep glass when it is raised before heating.

The GaAs single crystal was pulled up as follows using the apparatus illustrated in Figs. 1 to 3.

First, into the crucible 7 having an inside diameter of 90 mm and a depth of 100 mm was placed 1,700 g. of a polycrystal of GaAs, then 300 g. of $B_2O_3$ was placed thereon, and further the baffle plate 16 formed of BN was put on the upper surface thereof.

Then, the crucible 7 was placed inside the heating means 11 and the interior of the furnace 1 was vacuum-evacuated. Thereafter, the interior of the furnace 1 was pressurized to 100 bar with an inert gas such as argon, and the temperature of the heaters 11a, 11b and 11c was raised to 1,400°C, while that of the heater 11d was raised to 1,200°C, to melt GaAs. $B_2O_3$ was the first to melt and then the GaAs polycrystal melted and the baffle plate 16 floated on the feed melt 12 below the $B_2O_3$ which became about 11 mm in thickness due to its specific gravity. This melted state was confirmed through a peep glass (not shown) and the moving rods were moved down to immerse the baffle plate 16 into the feed melt 12 to a position in which the spacing between the upper surface of the baffle plate 16 now located below the surface of the melt and the lower surface of $B_2O_3$ was about 17 mm.

Then, the single crystal pulling-up rod 8 was moved down to immerse the seed crystal 14 attached to the fore end of the rod 8 into the feed melt 12 through $B_2O_3$, and the rod 10 was rotated at a rate of about 8 r.p.m. to have the seed crystal contacted thoroughly with the feed melt, while the crucible was rotated in the opposite direction also at a rate of 8 r.p.m., and the single crystal was pulled up in the direction of [111] at a rate of about 15 mm/h. During this pulling-up operation, the baffle plate 16 was moved down by the moving rods 18 to maintain its predetermined position below the surface of the feed melt.

The GaAs single crystal thus obtained was 50 mm in diameter and 250 mm in length, and its etch bit density was $1.2 \times 10^4$ cm$^{-2}$ at the portion 10 mm from the outer periphery, $4.2 \times 10^3$ cm$^{-2}$ at 15 mm from the outer periphery and $6.7 \times 10^4$ cm$^{-2}$ at 20 mm from the outer periphery. Defects such as dislocation was scarcely recognized in this single crystal, and thus the single crystal growing method of the present invention proved to be very superior even in comparison with the horizontal Bridgman method.

Although the above embodiment concerns pulling up a single crystal of GaAs, the process of the present invention is also applicable to the pulling up of single crystals of other semiconductors or compound semiconductors such as, for example, Si, Ge, GaP and IaP.

The baffle plate may be held down from above by moving rods, or alternatively the baffle plate and the moving rods may be integrally fixed to each other. The former is advantageous in that since the baffle plate is enclosed beforehand in the crucible, it is not an obstacle to the view of a peep glass no matter in which position the peep glass is located, but the former is disadvantageous in that the baffle plate remains in the crucible and solidifies together with the residual feed melt, thus running to waste at every manufacturing process. On the other hand, the latter is disadvantageous in that since the baffle plate must be pulled up outside the crucible before melting, the view of the peep glass is obstructed in some particular position thereof, but the latter is advantageous in that the baffle plate can be used repeatedly because it can be pulled up outside the crucible after completion of the single crystal pulling-up operation.

Further, it has been found that in the case where the baffle plate is of a small diameter and a large thickness and the moving rod is thick and strong, there may be used only one moving rod, but that in the case where the baffle plate is thin and the moving rod is not so thick, it is desirable to use plural moving rods, or else the support for the baffle plate would become unstable.

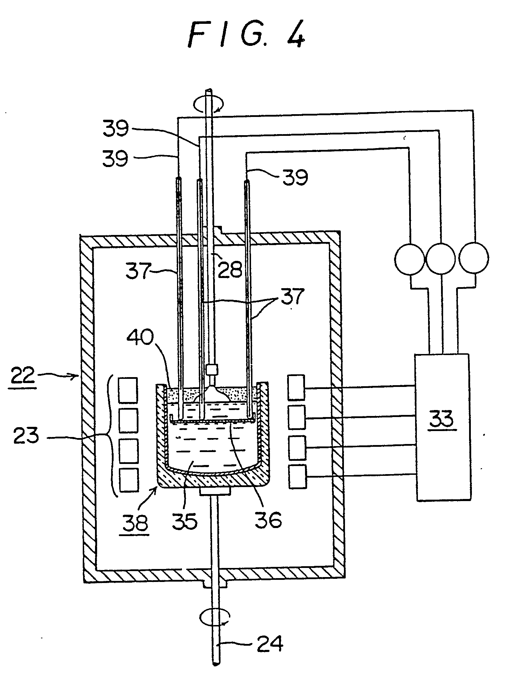

Referring now to Fig. 4, there is illustrated a further embodiment of the present invention, in which a baffle plate 36 for preventing heat convection is floated in a feed melt 35, and a plurality of moving rods 37 formed of, for example, BN for holding the baffle plate 36 are suspended vertically movably from above a crucible 38. In each of a moving rods 37 is enclosed a temperature measuring means 39 comprising a thermocouple, for example.

This arrangement is advantageous in that the temperatures of plural regions in the crucible 38 can be measured at a time whereby a more exact temperature control can be effected. In this embodiment, the temperature of the upper surface of the baffle plate 36, that of the upper surface of the feed melt 35 and that of the upper surface of a liquid sealing agent 40 can be measured at a time.

## Claims

1. A method of growing a single crystal, comprising pulling a single crystal from a feed melt contained in a crucible according to the Czochralski method, by applying a high pressure gas in the interior of a furnace, covering the surface of the feed melt with a liquid sealing agent, floating an unperforated baffle plate having an outside diameter somewhat smaller than the inside diameter of the crucible in a predetermined position below the surface of the feed melt to define a spacing between the baffle plate and the surface of the feed melt and to define a gap between the inner periphery of the crucible and the outer periphery of the baffle plate controlling the spacing between said baffle plate and the surface of the feed melt so that said spacing is maintained at a predetermined spacing during pulling of the single crystal, causing relative rotation between the baffle plate and the crucible, disposing a plurality of heating means coaxially around a crucible, and controlling said heating means each independently for heating said crucible.

2. A method of growing a single crystal according to claim 1, wherein said baffle plate is provided with feed melt guiding portions on the outer periphery thereof, said feed melt guiding portions smoothly guiding the feed melt from below the baffle plate through the gap between the baffle plate rotating with respect to the crucible and the crucible to a solid-melt interface region above the baffle plate.

3. A method of growing a single crystal according to claim 1, wherein said baffle plate is made from $Al_2O_3$, $Si_3N_4$, BN or PBN.

4. A method of growing a single crystal according to claim 1, wherein the rotational movement of said baffle plate is controlled while the baffle plate is pressed down by a plurality of moving rods which are suspended vertically movable from above the crucible.

5. A method of growing a single crystal according to claim 1, wherein said baffle plate is fixed to a moving rod which is suspended vertically movable from above the crucible.

6. A method of growing a single crystal according to claim 1, wherein said crucible is moved to maintain said predetermined position of said baffle plate in the crucible during pulling up of the single crystal.

7. A method of growing a single crystal according to claim 1, wherein said heating means include a single or plural temperature measuring means constructed to be axially movable into the crucible containing the feed melt, said temperature measuring means functioning to measure the temperature of a desired region in said crucible, and said heating means being controlled each independently in accordance with a detecting signal provided from said temperature measuring means.

8. A method of growing a single crystal according to claim 7, wherein said temperature measuring means is (or are) enclosed in a single or plural moving rods which support or hold the baffle plate floated in the feed melt in the crucible.

9. A method of growing a single crystal according to claim 7, wherein said temperature measuring means is a thermocouple.

10. An apparatus for growing a single crystal, including a pressure- and heat-resistant electric furnace, a single crystal pulling-up shaft which is drivable by a magnetic mechanism in said electric furnace, a feed melt holding crucible fixed on top of a crucible supporting rod which is also drivable by a magnetic mechanism in said electric furnace, a baffle plate in use held in a predetermined position below the surface of the feed melt in said crucible, a baffle plate moving means for in use maintaining the spacing between said baffle plate and the surface of the feed melt at a predetermined spacing during pulling up of the single crystal, said baffle plate moving means having moving rods for moving said baffle plate, said moving rods in use being driven by a magnetic mechanism, a plurality of heating means arranged axially vertically around said crucible, and means for in use independently controlling said heating means.

11. An apparatus for growing a single crystal according to claim 10, wherein said baffle plate has a diameter which allows a slight gap to be formed between the baffle plate and the inner wall of the crucible.

12. An apparatus for growing a single crystal according to claim 10, wherein said baffle plate has a wavy unevenness formed circumferentially upward.

13. An apparatus for growing a single crystal according to claim 10, wherein said baffle plate is formed of $Al_2O_3$, $Si_3N_4$, BN or PBN.

14. An apparatus for growing a single crystal according to claim 10, wherein said heating means each comprise a molybdenum heater.

**Patentansprüche**

1. Verfahren zum Züchten eines Einkristalls, wobei ein Einkristall gemäß dem Czochralski-Verfahren aus einer in einem Schmelztiegel enthaltenen speisenden Schmelze gezogen wird, indem ein unter hohem Druck stehendes Gas im Inneren eines Ofens angewendet wird, die Oberfläche der speisenden Schmelze mit einem flüssigen Dichtmittel bedeckt wird, eine perforationsfreie Trennscheibe mit einem Außendurchmesser, der etwas kleiner als der Innendurchmesser des Schmelztiegels ist, in einer vorgegebenen schwimmenden Position unter der Oberfläche der speisenden Schmelze gehalten wird, um einen Zwischenraum zwischen der Trennscheibe und der Oberfläche der speisenden Schmelze zu definieren und um einen Spalt zwischen der inneren Umfangsfläche des Schmelztiegels und dem äußeren Umfang der Trennscheibe zu definieren, welcher den Zwischenraum zwischen der Trennscheibe und der Oberfläche der speisenden Schmelze reguliert, damit der Zwischenraum während des Ziehens des Einkristalls auf einem vorgegebenen Zwischenraum gehalten wird; ferner eine relative Drehbewegung zwischen der Trennscheibe und dem Schmelztiegel veranlaßt wird, eine Mehrzahl von Heizelementen koaxial um einen Schmelztiegel angeordnet wird, und die Heizelemente zum Heizen des Schmelztiegels jeweils unabhängig geregelt werden.

2. Verfahren zum Züchten eines Einkristalls nach Anspruch 1, wobei die Trennscheibe an ihrem äußeren Umfang mit Teilen zum Führen der speisenden Schmelze versehen wird, die die speisende Schmelze gleichmäßig aus dem Bereich unter der Trennscheibe durch den Spalt zwischen der sich bezüglich des Schmelztiegels drehenden Trennscheibe und dem Schmelztiegel in einen Übergangsbereich zwischen fester und flüssiger Phase oberhalb der Trennscheibe führen.

3. Verfahren zum Züchten eines Einkristalls nach Anspruch 1, wobei die Trennscheibe aus $Al_2O_3$, $Si_3N_4$, BN oder PBN besteht.

4. Verfahren zum Züchten eines Einkristalls nach Anspruch 1, wobei die Drehbewegung der Trennscheibe gesteuert wird, während die Trennscheibe durch eine Mehrzahl sich bewegender Stäbe nach unten gedrückt wird, die von oberhalb des Schmelztiegels vertikal herabbeweglich aufgehängt sind.

5. Verfahren zum Züchten eines Einkristalls nach Anspruch 1, wobei die Trennscheibe an einem sich bewegenden Stab befestigt ist, der von oberhalb des Schmelztiegels vertikal herabbeweglich aufgehängt ist.

6. Verfahren zum Züchten eines Einkristalls nach Anspruch 1, wobei der Schmelztiegel bewegt wird, um die vorgegebene Position der Trennscheibe im Schmelztiegel während des Ausziehens des Einkristalls aufrechtzuerhalten.

7. Verfahren zum Züchten eines Einkristalls nach Anspruch 1, wobei die Heizelemente eine einfache oder mehrfache Temperaturmeßvorrichtung umfassen, die so konstruiert ist, daß sie in Axialrichtung in den die speisende Schmelze enthaltenden Schmelztiegel bewegt werden kann; die Temperaturmeßvorrichtung in der Weise funktioniert, daß sie die Temperatur einer ausgewählten Zone im Schmelztiegel mißt; und die Heizelemente gemäß einem von der Temperaturmeßvorrichtung gelieferten Erfassungssignal jeweils unabhängig geregelt werden.

8. Verfahren zum Züchten eines Einkristalls nach Anspruch 7, wobei die Temperaturmeßvorrichtung(en) in einem bzw. mehreren Stäben enthalten ist bzw. sind, die die Trennscheibe in der speisende Schmelze im Schmelztiegel in ihrem Schwimmzustand stützen oder halten.

9. Verfahren zum Züchten eines Einkristalls nach Anspruch 7, wobei die Temperaturmeßvorrichtung ein Thermoelement ist.

10. Einrichtung zum Züchten eines Einkristalls, mit einem druck- und hitzebeständigen Elektroofen, einer mittels eines magnetischen Mechanismus im Elektroofen antreibbaren Welle zum Ausziehen des Einkristalls, einem die speisende Schmelze haltenden Schmelztiegel, der am oberen Ende eines Schmelztiegel-Stützstabs befestigt ist, der ebenfalls mittels eines magnetischen Mechanismus im Elektroofen antreibbar ist; einer Trennscheibe, die im Betrieb in einer vorgegebenen Position unterhalb der Oberfläche der speisenden Schmelze im Schmelztiegel gehalten wird; einer Vorrichtung zum Bewegen der Trennscheibe, um im Betrieb den Zwischenraum zwischen der Trennscheibe und der Oberfläche der speisenden Schmelze während des Ausziehens des Einkristalls bei einem vorgegebenen Zwischenraum zu halten, wobei die Vorrichtung zum Bewegen der Trennscheibe Bewegungsstäbe zum Bewegen der Trennscheibe aufweist, welche im Betrieb von einem magnetischen Mechanismus angetrieben werden; einer Mehrzahl von in Axialrichtung vertikal rund um den Schmelztiegel angeordneten Heizelementen und einer Vorrichtung zum unabhängigen Regeln der Heizelemente im Betrieb.

11. Einrichtung zum Züchten eines Einkristalls nach Anspruch 10, wobei die Trennscheibe einen Durchmesser hat, der die Bildung eines kleinen Spalts zwischen der Trennscheibe und der Innenwand des Schmelztiegels ermöglicht.

12. Einrichtung zum Züchten eines Einkristalls nach Anspruch 10, wobei die Trennscheibe eine wellige, am Umfang nach oben gerichtete Ungleichmäßigkeit aufweist.

13. Einrichtung zum Züchten eines Einkristalls nach Anspruch 10, wobei die Trennscheibe aus $Al_2O_3$, $Si_3N_4$, BN oder PBN besteht.

14. Einrichtung zum Züchten eines Einkristalls nach Anspruch 10, wobei die Heizelemente jeweils ein Molybdän-Heizelement umfassen.

**Revendications**

1. Procédé pour former un monocristal, dans lequel on produit un monocristal à partir d'une masse fondue contenue dans un creuset selon le procédé de Czochralski, consistant à introduire un gaz sous haute pression à l'intérieur d'un four, à recouvrir la surface de la masse fondue à l'aide d'un agent d'étanchéité liquide, à faire flotter un déflecteur non-perforé, ayant un diamètre extérieur légèrement inférieur au diamètre intérieur du creuset, à une position prédéterminée en-dessous de la surface de la masse fondue, pour définir un espacement entre le déflecteur et la surface de la masse fondue et pour définir un intervalle entre la périphérie intérieure du creuset et la périphérie extérieure du déflecteur, à ajuster l'espacement entre ledit déflecteur et la surface de la masse fondue de telle sorte que ledit espacement soit maintenu à une valeur prédéterminée pendant la tirage du monocristal, ce qui provoque une rotation relative entre le déflecteur et le creuset; à disposer une pluralité de moyens de chauffage coaxialement autour du creuset; et à commander lesdits moyens de chauffage, chacun indépendamment les uns des autres, pour chauffer ledit creuset.

2. Procédé pour former un monocristal selon la revendication 1, dans lequel ledit déflecteur est pourvu sur sa périphérie extérieure de parties de guidage de la masse fondue guident sans à-coups la masse fondue à partir d'un point situé en-dessous du déflecteur, à travers l'intervalle précité-défini, entre le déflecteur tournant et le creuset, pour amener cette masse fondue à une zone d'interface solide-masse fondue située au-dessus du déflecteur.

3. Procédé pour former un monocristal selon la revendication 1, dans lequel ledit déflecteur est formé de $Al_2O_3$, $Si_3N_4$, BN ou PBN.

4. Procédé pour former un monocristal selon la revendication 1, dans lequel le mouvement de rotation dudit déflecteur est réglé cependant que le déflecteur est poussé vers le bas par une pluralité de tiges déplaçables verticalement à partir d'un niveau situé au-dessus du creuset.

5. Procédé pour former un monocristal selon la revendication 1, dans lequel ledit déflecteur est fixé à une tige mobile déplaçable verticalement à partir d'un point situé au-dessus du creuset.

6. Procédé pour former un monocristal selon la revendication 1, dans lequel ledit creuset est déplacé pour maintenir ladite position prédéterminée dudit déflecteur dans le creuset pendant le tirage du monocristal.

7. Procédé pour former un monocristal selon la revendication 1, dans lequel lesdits moyens de chauffage comprennent un ou plusieurs moyens thermométriques déplaçables axialement jusqu'à l'intérieur du creuset contenant la masse fondue, lesdits moyens thermométriques étant appelés à mesurer la température d'une zone choisie à l'intérieur dudit creuset, et lesdits moyens de chauffage étant commandés, chacun indépendamment des autres, en fonction d'un signal de détection envoyé par lesdits moyens thermométriques.

8. Procédé pour former un monocristal selon la revendication 7 dans lequel ledit ou lesdits moyens thermométriques sont enfermés dans une ou plusieurs tiges mobiles supportant ou maintenant le déflecteur qui flotte dans le bain de fusion se trouvant dans le creuset.

9. Procédé pour former un monocristal selon la revendication 7, dans lequel lesdits moyens thermométriques sont constitués par un couple thermoélectrique.

10. Appareil pour former un monocristal, comprenant un four électrique résistant à la pression et à la chaleur, un arbre de tirage de monocristaux susceptible d'être entraîné par un mécanisme magnétique disposé dans ledit four électrique, un creuset recevant une masse fondue, fixé à la partie supérieure d'une tige de soutènement de creuset qui est également susceptible d'être entraînée par un mécanisme magnétique disposé dans ledit four électrique, un déflecteur appelé à être maintenu dans une position prédéterminée en-dessous de la surface de la masse fondue contenue dans ledit creuset, un moyen de déplacement du déflecteur destiné à maintenir l'espacement entre ledit déflecteur et la surface de la masse fondue à une valeur prédéterminée pendant le tirage du monocristal, ledit moyen de déplacement du déflecteur possédant des tiges mobiles destinées à déplacer ledit déflecteur, lesdites tiges mobiles étant entraînées par un mécanisme magnétique, une pluralité de moyens de chauffage disposés axialement et verticalement autour dudit creuset, et un moyen pour réguler indépendamment les uns des autres lesdits moyens de chauffage.

11. Appareil pour former un monocristal selon la revendication 10, dans lequel ledit déflecteur présente un diamètre qui autorise la formation d'un faible intervalle entre le déflecteur et la paroi intérieure du creuset.

12. Appareil pour former un monocristal selon la revendication 10, dans lequel le déflecteur présente un profil légèrement ondulé en direction périphérique et vers le haut.

13. Appareil pour former un monocristal selon la revendication 10, dans lequel ledit déflecteur est formé de $Al_2O_3$, $Si_3N_4$, BN ou PBN.

14. Appareil pour former un monocristal selon la revendication 10, dans lequel chacun desdits moyens de chauffage comprend un élément chauffant au molybdène.

# F I G.  1

# F I G. 2

# F I G. 3

○——○ Baffle Plate
△--△ None Baffle Plate

# F I G. 4